# EUROPEAN PATENT APPLICATION

(11) **EP 2 106 028 A1**
(43) Date of publication of application: **30.09.2009**
(21) Application number: 08005565.0
(22) Date of filing: 26.03.2008
(51) Int. Cl.: H03L 1/02

(54) **Circuit arrangement and method of operation**

(71) Applicant: Nokia Siemens Networks Oy, 02610 Espoo (FI)
(72) Inventor: The designation of the inventor has not yet been filed
(74) Representative: Krombach, Rainer

(57) **Abstract**

A circuit arrangement is provided comprising a crystal capable of producing a fundamental tone and a 3rd overtone; a first circuit; a second circuit; wherein the first circuit and the second circuit are connected to the crystal thereby providing a voltage to said crystal to excite said crystal. Further, a method of adjusting an oscillating circuit utilizing said circuit arrangement is suggested.

## Description

Current GSM Base Stations use an OCXO (Oven controlled crystal oscillator) as a stable synchronization source. A Microcontroller Compensated Crystal Oscillator (MCXO) has been provided as a low cost alternative for the OCXO. In the MCXO, the thermal error of the crystal frequency is corrected using a microcomputer. The main component of the MCXO is an stress compensated (SC) cut crystal capable of producing two tones, one is a fundamental tone and the other is the 3rd overtone thereof. The difference between the fundamental tone and the 1/3 of the 3rd overtone is called beat frequency and has a linear relationship with temperature. From this relationship, it is possible to determine the exact operational temperature of the circuit and create the frequency error artificially using a digital device, such as a FPGA or a DDS.

The MCXO can be designed with an analog circuit component as well as with a digital circuit component.

A SC cut crystal can simultaneously operate in two modes, i.e., the fundamental frequency and the 3rd overtone frequency. The difference between the fundamental frequency and 1/3 of the 3rd overtone frequency has a linear relationship with temperature. As a result, this behavior can be used as a temperature indicator for correcting the frequency error resulting from temperature changes.

This allows not to use an expensive OCXO within a Base Station. In an OCXO, the frequency error is normally compensated with an analog technique in addition to creating a stable temperature oven that surrounds the SC cut crystal.

Hence, said expensive OCXO can be replaced by said MCXO comprising crystals allocated for each of the two overtones used. However, such design leads to two SC cut crystals in order to build the MCXO.

The **problem** to be solved is to overcome the disadvantages stated above and in particular to provide an efficient MCXO.

This problem is solved according to the features of the independent claims. Further embodiments result from the depending claims.

In order to overcome this problem, a circuit arrangement is provided comprising
- a crystal capable of producing a fundamental tone and a 3rd overtone;
- a first circuit;
- a second circuit;
- wherein the first circuit and the second circuit are connected to the crystal thereby providing a voltage to said crystal to excite said crystal.

Hence, the first and the second circuit each provides an input voltage, in particular a minimum input voltage, to the crystal that allows said crystal to get stimulated.

This approach advantageously allows a solution for a dual mode oscillator utilizing one single SC cut crystal only.

This efficiently avoids deployment of expensive OXCOs, in particular as there is no need for a temperature-controlled oven.

The approach suggested facilitates in particular a stress-compensated (SC) cut crystal in a way that it gets to oscillate. This is achieved by supplying a minimum amount of energy in terms of a voltage to the SC cut crystal to get it excited.

In an embodiment, the first circuit and the second circuit are connected to a power source.

In particular, the first circuit and the second circuit can be connected to the same power source, e.g., a voltage supply source.

In another embodiment, the first circuit comprises an oscillator that is tuned to the fundamental tone of the crystal.

In a further embodiment, the first circuit comprises a filter that is tuned to the fundamental tone of the crystal.

In a next embodiment, said filter comprises a ceramic filter and/or at least one inductor and at least one capacitor.

It is also an embodiment that the second circuit comprises an oscillator that is tuned the 3rd overtone of the crystal.

Pursuant to another embodiment, the second circuit comprises a filter that is tuned to the 3rd overtone.

According to an embodiment, said filter comprises a ceramic filter and/or at least one inductor and at least one capacitor.

According to another embodiment, the oscillator comprises at least one Colpitts oscillator.

In yet another embodiment, the first circuit provides a first output signal and the second circuit provides a second output signal and a temperature is determined based on a difference of the first output signal and the second output signal.

According to a next embodiment, said difference of the first output signal and the second output signal is utilized to adjust a frequency of a further oscillator.

Pursuant to yet an embodiment, said further oscillator is used in a base station of a mobile communication networks, in particular a GSM, a UMTS base station or any upcoming technology like, e.g., LTE.

The solution provided, however, is not limited to GSM base stations but can in particular be applied to other base stations where OCXOs are used.

According to a further embodiment, the crystal is a stress-compensated cut crystal.

The problem stated supra is further solved by method for adjusting an oscillating circuit comprising the circuit arrangement as described herein.

Further, the problem stated above may be solved by a method for temperature compensation comprising the circuit arrangement as described herein.

Embodiments of the invention are shown and illustrated in the following figures:
- Fig.1: shows an exemplary circuit arrangement utilizing a single SC cut crystal in order to obtain a fundamental frequency and a 3rd overtone;
- Fig.2: shows a dual mode oscillator arrangement utilizing a single SC cut crystal in order to obtain a fundamental frequency and a 3rd overtone.

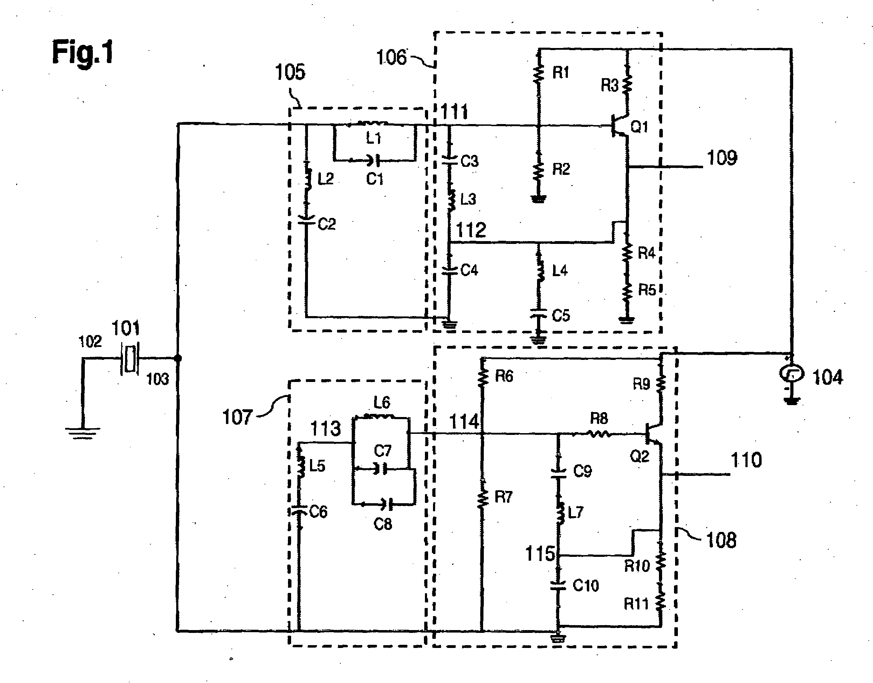

**Fig.1** shows an exemplary circuit arrangement that provides output signals for determining a temperature drift.

The circuit arrangement of Fig.1 comprises a Colpitts oscillator 108 for the fundamental tone, a Colpitts oscillator 106 for the 3rd overtone, an isolation branch 105 for the 3rd overtone and an isolation branch 107 for the fundamental tone.

The isolation branch 105 and the oscillator 106 may be summarized as a first circuit and the isolation branch 107 and the oscillator 108 can be summarized as a second circuit. Both, the first circuit and the second circuit provide a voltage to a port 103 of a stress-compensated cut crystal 101, which is connected with its other port 102 to ground.

The port 103 is further connected to an inductor L2, a capacitor C1 and an inductor L1, wherein the other pin of the inductor L2 is connected via a capacitor C2 to ground. The other side of the inductor L1 and of the capacitor C1 is each connected to a node 111 (hence, the capacitor C1 and the inductor L1 are connected in parallel).

A capacitor C3 is connected to node 111 and its other pin is connected via an inductor L3 to a node 112. A capacitor C4 is inserted between node 112 and ground. Further, a series connection of an inductor L4 and a capacitor C5 is inserted between node 112 and ground. Also, a series connection of a resistor R4 and a resistor R5 is inserted between node 112 and ground. Node 112 is further connected to an output 109 and to an emitter of a transistor Q1. The base of transistor Q1 is connected to node 111 and the collector of transistor Q1 is connected via a resistor R3 to a supply voltage 104. A resistor R2 is inserted between node 111 and ground and a resistor R1 is inserted between node 111 and the supply voltage 104.

In addition, port 103 of the SC cut crystal is also connected to ground and to one side of a capacitor C6, which other side is connected via an inductor L5 with a node 113. An inductor L6, a capacitor C7 and a capacitor C8 are connected in parallel and are inserted between node 113 and a node 114.

A resistor R7 is inserted between node 114 and ground and a resistor R6 is inserted between node 114 and the supply voltage 104. Node 114 is also connected to a capacitor C9, which other side is connected via an inductor L7 to a node 115. A capacitor C10 is inserted between node 115 and ground. Also, a series connection of a resistor R10 and a resistor R11 are inserted between node 115 and ground. Node 115 is further connected to output 110 and to the emitter of a transistor Q2. The base of transistor Q2 is connected via a resistor R8 to node 114. The collector of transistor Q2 is connected via a resistor R9 to the supply voltage 104.

The circuit arrangement of Fig.1 utilizes two Colpitts oscillators 106 and 108 connected to the single SC cut crystal 101 via two isolation branches 105 and 107.

Each of the Colpitts oscillators 106 and 108 is individually tuned to a specific frequency of the crystal 101. The oscillator 108 is tuned to fundamental frequency and the oscillator 106 is tuned to the 3rd overtone frequency.

The SC cut crystal 101 also exhibits B-mode frequency for each of the C-mode frequencies. In order to suppress the B-mode frequency, a trap is set in each of the Colpitts oscillators 106 and 108. The inductor L3 and the capacitor C3 act as a trap for the 3rd overtone B-mode, while the inductor L7 and the capacitor C9 act as a trap for the fundamental B-mode frequency.

Each of the Colpitts circuits 106 and 108 is connected to the crystal 101 through an isolation branch 105 and 107. Each isolation branch suppress the unwanted tone: Isolation branch 105 blocks the fundamental tone and simultaneously isolation branch 107 blocks the 3rd overtone.

The outputs 109 and 110 provide signals regarding a 3rd overtone and a fundamental tone. The difference between these two tones (beat frequency) has a linear relationship with temperature. From this relationship, it is possible to determine the exact operational temperature of the circuit and create the frequency error artificially using a digital device, such as a FPGA or a DDS. This frequency error can be used in order to compensate a frequency drift due to temperature shift and thus provide a constant frequency source for a device, e.g. a base station of a mobile communication network, in particular a GSM base station or a UMTS base station.

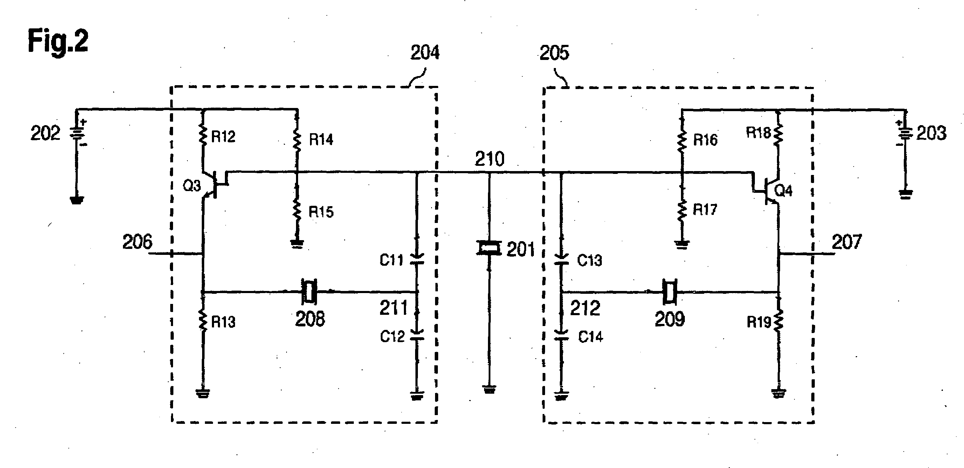

**Fig.2** shows an example of a dual mode oscillator circuit arrangement.

In Fig.2, a first circuit 204 is connected to a power supply 202 and to a port 210 of a single SC cut crystal 201

A resistor R12 is inserted between the power supply 202 and the collector of a transistor Q3 and a resistor R14 is inserted between the power supply 202 and a base of the transistor Q3, which is further connected to the port 210 of the crystal 201. A resistor R15 is inserted between the base of the transistor Q3 and ground. The emitter of the transistor Q3 is connected to an output 206 and further via a resistor R13 to ground. The output 206 is further connected via a ceramic filter 208 with a node 211. Such node 211 is further connected via a capacitor C12 to ground and via a capacitor C11 to said port 210 of the crystal 201.

Further, a second circuit 205 is connected to a power supply 203 and to said port 210 of the crystal 201.

A resistor R18 is inserted between the power supply 203 and the collector of a transistor Q4 and a resistor R16 is inserted between the power supply 203 and a base of the transistor Q4, which is further connected to the port 210 of the crystal 201. A resistor R17 is inserted between the base of the transistor Q4 and ground. The emitter of the transistor Q4 is connected to an output 207 and further via a resistor R19 to ground. The output 207 is further connected via a ceramic filter 209 with a node 212. Such node 212 is further connected via a capacitor C14 to ground and via a capacitor C13 to said port 210 of the crystal 201.

The circuit arrangement of Fig.2 comprises two Colpitts oscillators. One oscillator is tuned to the fundamental frequency and the other oscillator is tuned to the 3rd overtone. Both are directly driven by the single cut crystal 201.

Both Colpitts circuits are tuned to the overtone frequency using a ceramic band pass filter, which offers high Q selectivity. The use of the ceramic filters eliminates the need to use low Q tuned inductors and capacitors as tuners.

The bias circuit is advantageous for exciting the SC-cut crystal 201. Preferably both Colpitts oscillators are biased substantially identical, because they are connected to the same port 210 of the crystal 201. This allows to change the bias voltage of the crystal port 210 beyond its minimum requirement to get the crystal excited.

The outputs 206 and 207 provide signals regarding a 3rd overtone and a fundamental tone. The difference between these two tones (beat frequency) has a linear relationship with temperature. From this relationship, it is possible to determine the exact operational temperature of the circuit and create the frequency error artificially using a digital device, such as a FPGA or a DDS. This frequency error can be used in order to compensate a temperature shift within a device, e.g. a base station of a mobile communication network, in particular a GSM base station or a UMTS base station.

The circuit arrangements shown can be used with a microcontroller compensated crystal oscillator (MCXO).

### Abbreviations:

- BTS: Base station
- MCXO: Microcontroller Compensated Crystal Oscillator
- OCXO: Oven controlled Crystal Oscillator
- SC: Stress Compensated

## Claims

1. A circuit arrangement comprising
- a crystal capable of producing a fundamental tone and a 3rd overtone;
- a first circuit;
- a second circuit;
- wherein the first circuit and the second circuit are connected to the crystal thereby providing a voltage to said crystal to excite said crystal.

2. The circuit arrangement according to claim 1, wherein the first circuit and the second circuit are connected to a power source.

3. The circuit arrangement according to any of the preceding claims, wherein the first circuit comprises an oscillator that is tuned to the fundamental tone.

4. The circuit arrangement according to claim 3, wherein the first circuit comprises a filter that is tuned to the fundamental tone.

5. The circuit arrangement according to claim 4, wherein said filter comprises a ceramic filter and/or at least one inductor and at least one capacitor.

6. The circuit arrangement according to any of the preceding claims, wherein the second circuit comprises an oscillator that is tuned the 3rd overtone.

7. The circuit arrangement according to claim 6, wherein the second circuit comprises a filter that is tuned to the 3rd overtone.

8. The circuit arrangement according to claim 7, wherein said filter comprises a ceramic filter and/or at least one inductor and at least one capacitor.

9. The circuit arrangement according to any of the preceding claims, wherein the oscillator comprises at least one Colpitts oscillator.

10. The circuit arrangement according to any of the preceding claims,
- wherein the first circuit provides a first output signal and the second circuit provides a second output signal;
- wherein a temperature is determined based on a difference of the first output signal and the second output signal.

11. The circuit arrangement according to claim 10, wherein said difference of the first output signal and the second output signal is utilized to generate an adjusted clock frequency.

12. The circuit arrangement according to claim 11, wherein said adjusted clock frequency is used in a base: station of a mobile communication networks, in particular a GSM or a UMTS base station.

13. The circuit arrangement according to any of the preceding claims, wherein the crystal is a stress-compensated cut crystal.

14. A method for adjusting an oscillating circuit comprising the circuit arrangement according to any of the preceding claims.

15. A method for temperature compensation comprising the circuit arrangement according to any of the claims 1 to 13.
